Europäisches Patentamt

European Patent Office

Office européen des brevets

(19)

(11) Veröffentlichungsnummer : **0 552 390 B1**

(12) # EUROPÄISCHE PATENTSCHRIFT

(45) Veröffentlichungstag der Patentschrift :
27.09.95 Patentblatt 95/39

(51) Int. Cl.⁶ : **H01S 3/103**

(21) Anmeldenummer : **92100886.8**

(22) Anmeldetag : **20.01.92**

(54) **Abstimmbare Laserdiode.**

(43) Veröffentlichungstag der Anmeldung :
28.07.93 Patentblatt 93/30

(45) Bekanntmachung des Hinweises auf die
Patenterteilung :
27.09.95 Patentblatt 95/39

(84) Benannte Vertragsstaaten :
**DE FR GB IT**

(56) Entgegenhaltungen :
**IEE PROCEEDINGS - PART J Bd. 137, Nr. 1,
Februar 1990, STEVENAGE GB Seiten 69 - 73;
C.F.J. SCHANEN ET AL.: 'Fabrication and lasing characteristics of a lambda=1.56 mum
tunable twin-guide (TTG) DFB lasers'
PATENT ABSTRACTS OF JAPAN, Bd. 15, Nr.
295 (E-1094)26. Juli 1991; & JP-A-3105992
PATENT ABSTRACTS OF JAPAN, Bd. 12, Nr.
13 (E-573)14. Januar 1988; & JP-A-62173786
PATENT ABSTRACTS OF JAPAN, Bd. 15, Nr.
165 (E-1061)25. April 1991; & JP-A-3035581**

(73) Patentinhaber : **SIEMENS
AKTIENGESELLSCHAFT
Wittelsbacherplatz 2
D-80333 München (DE)**

(72) Erfinder : **Amann, Markus-Christian, Dr.
Unterhachinger Strasse 89
W-8000 München 83 (DE)**

EP 0 552 390 B1

**Beschreibung**

Die vorliegende Erfindung betrifft eine abstimmbare Laserdiode auf der Grundlage der TTG-Laserdiode.

In der modernen optischen Nachrichtentechnik (z. B. Wellenlängenmultiplexsysteme), in der Meßtechnik (z. B. Entfernungsmessung) und in der Sensorik (z. B. Luftanalyse mittels Infrarotspektroskopie) werden elektronisch durchstimmbare Laserdioden mit sehr großem Abstimmbereich benötigt. Eine abstimmbare Laserdiode mit transversal zueinander angeordneter aktiver Schicht und Abstimmschicht ist in der europäischen Patentanmeldung EP 0 360 011 beschrieben (TTG-Laser). Für einen besonders weiten Abstimmbereich existierten bisher vorwiegend hybride Konstruktionen aus einer Laserdiode und einem externen Resonator mit mechanischer Wellenlängeneinstellung. Monolithisch integrierte Lösungen sind z. B. der ACA-Laser oder der Y-Laser. Beim ACA-Laser (s. ECOC'91/IOOC'91, 3 Post-Deadline papers, Seite 21 bis 24) wird das Prinzip der Vorwärtskopplung ausgenutzt zur Vergrößerung des Abstimmbereiches. Ein Nachteil des ACA-Lasers stellt die longitudinale Sektionierung in drei Zonen dar, welche die Herstellung des Bauelementes erschwert und die Laserlänge erhöht. Der Y-Laser (s. M. Schilling u. a.: "Widely tunable Y-coupled cavity integrated interferometric injection laser" in Electron. Lett. 26, 243 - 244 (1990)) weist den entscheidenden Nachteil einer sehr komplizierten Ansteuerung durch vier Steuerströme auf, wobei die Steuerfunktionen Lichtleistung und Wellenlänge nicht exakt getrennt sind, sondern gleichzeitig von allen vier Steuerströmen beeinflußt werden.

Aufgabe der vorliegenden Erfindung ist es, eine abstimmbare Laserdiode anzugeben, die einfach herstellbar ist und einen besonders weiten Abstimmbereich aufweist.

Diese Aufgabe wird mit der Laserdiode mit den Merkmalen des Anspruches 1 gelöst. Weitere Ausgestaltungen ergeben sich aus den abhängigen Ansprüchen.

Bei der erfindungsgemäßen Laserdiode sind zwei Wellenleiterschichten nach dem Prinzip der TTG-Laserdiode transversal parallel zueinander angeordnet. Diese Wellenleiterschichten lassen sich über eine dazwischenliegende Schicht und separate Kontakte getrennt ansteuern. Zusätzlich ist eine periodisch unterbrochene Absorberschicht in der Nähe dieser Wellenleiterstruktur angeordnet. In den Wellenleiterschichten werden zwei verschiedene Moden geführt. Beide Moden werden durch die periodisch aufeinanderfolgende An- bzw. Abwesenheit der Absorberschicht in ihrer Form beeinflußt, wodurch die Feldstärke dieser Moden in unterschiedlicher Weise beeinflußt wird. Diese periodische Störung der ansonsten unverkoppelten Felder führt zu einer Kopplung der beiden Moden. Da die beiden Moden in die gleiche Richtung laufen, liegt hierbei codirektionale Kopplung oder Vorwärtskopplung vor.

Mit der vorliegenden Erfindung ergibt sich, daß die Kopplungsstärke komplex mit nicht verschwindendem Imaginärteil ist. Im Idealfall wäre die Kopplungsstärke rein imaginär. Die Stärke der Kopplung wird durch das Integral für die Überlappung je eines Modes in einem Gebiet der Wellenleiterstruktur ohne angrenzende Absorberschicht mit dem jeweils anderen Mode im Gebiet mit angrenzender Absorberschicht bestimmt. Durch den von 0 verschiedenen Imaginärteil dieser Kopplungsstärke ist gewährleistet, daß eine Filterwirkung beim Laserbetrieb auftritt. Ein von 0 verschiedener Realteil dieser Kopplungsstärke bewirkt anstelle der Bandfilterung eine Bandsperre, was für den Laserbetrieb nicht günstig wäre, weil dadurch die abzustimmende Wellenlänge unterdrückt oder zumindest nicht ausreichend verstärkt würde. Diese abzustimmende Wellenlänge ist die Koppelwellenlänge, d. h. die Wellenlänge mit maximaler Filterwirkung. Sie kann mittels des Stromes, der eine Ladungsträgerinjektion in die für die Abstimmung vorgesehene Wellenleiterschicht bewirkt, in weiten Bereichen eingestellt werden. Der Mechanismus dieser Abstimmung ist die Änderung der Brechzahl der für die Abstimmung vorgesehenen Wellenleiterschicht durch die darin injizierten Ladungsträger. Wie von der genannten ACA-Laserdiode her bekannt ist, ist die Größe des Abstimmbereiches aufgrund der Vorwärtskopplung bei optimaler Dimensionierung nur noch von der materialabhängigen Breite der Laserverstärkungskurve begrenzt.

Es folgt eine Beschreibung von Ausführungsformen der erfindungsgemäßen Laserdiode anhand der Figuren 1 bis 8.

Fig. 1          zeigt eine erfindungsgemäße Laserdiode im Längsschnitt.

Fig. 2          zeigt eine erfindungsgemäße Laserdiode in dem in Fig. 1 bezeichneten Querschnitt.

Fig. 3          zeigt einen Ausschnitt des in Fig. 1 dargestellten Längsschnittes mit den für Fig. 4 maßgeblichen Schnittebenen.

Fig. 4          stellt qualitativ den Verlauf der Feldstärke vertikal zur Schichtstruktur dar.

Fig. 5 und 6     zeigen einen Ausschnitt des Längsschnittes nach Fig. 1 mit zusätzlich vorhandenen Kompensationsschichten.

Fig. 7 und 8     zeigen Ausschnitte von Längsschnitten alternativer Ausführungsformen.

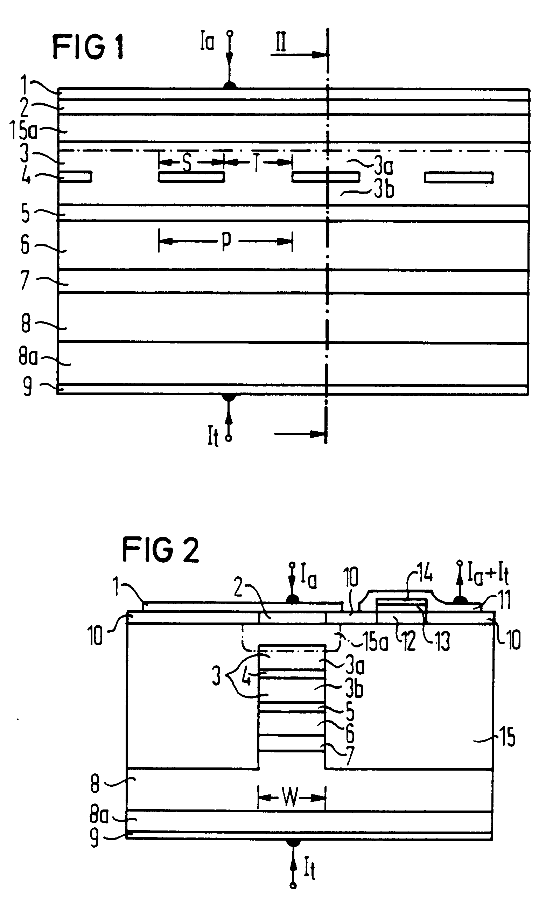

In dem Längsschnitt in Fig. 1 und dem zugehörigen Querschnitt in Fig. 2 sind die Wellenleiterschichten 5, 7, die Zwischenschicht 6 und die Absorberschicht 4 mit periodischen Unterbrechungen eingezeichnet. Die laterale Struktur, wie in Fig. 2 gezeigt, ist an sich schon vom TTG-Laser her bekannt und soll an dieser Stelle nur als Beispiel zur Realisierung der seitlichen Strom- und Wellenführung dienen. Es können aber genausogut andere geeignete Lateralstrukturen verwendet werden. Maßgeblich für die vorliegende Erfindung ist jedoch die axiale Struktur des Laserresonators, wie in Bild 1 gezeigt. Die Länge S der jeweiligen Abschnitte der Absorberschicht und die Länge T der jeweiligen Unterbrechungen addieren sich zu der Periode P. Bei dem speziellen Ausführungsbeispiel, wie es in Fig. 1 dargestellt ist, sind auf einem Substrat 8a übereinander eine untere Mantelschicht 8, eine untere Wellenleiterschicht 7, die Zwischenschicht 6, eine obere Wellenleiterschicht 5 und eine obere Mantelschicht 3 mit der darin eingebetteten Absorberschicht 4 aufgewachsen. Diese Schichten bilden einen Steg, wie in der Fig. 2 zu erkennen ist. Die seitlichen Bereiche auf der unteren Mantelschicht 8 sind durch eine laterale Mantelschicht 15 aufgefüllt. Diese laterale Mantelschicht 15 kann den Steg vollständig überdecken.

Die Wellenleiterschichten 5, 7 sind vorzugsweise undotiert. Die Zwischenschicht 6 ist für einen ersten Leitfähigkeitstyp elektrisch leitend dotiert. Die an die Wellenleiterschichten 5, 7 nach unten und oben hin anschließenden Schichten sind jeweils für den zweiten Leitungstyp elektrisch leitend dotiert. Die laterale Mantelschicht 15 ist für den Leitungstyp der Zwischenschicht 6 dotiert. Falls der Steg von dieser lateralen Mantelschicht vollständig überwachsen ist, ist oberhalb des Steges in dieser lateralen Mantelschicht 15 durch Diffusion oder Implantation ein Anschlußbereich 15a mit demselben Vorzeichen wie die obere Mantelschicht ausgebildet.

Über den Steg ist auf der oberen Mantelschicht 3 bzw. auf dem Anschlußbereich 15a streifenförmig eine Kontaktschicht 2, die lateral von Isolatorschichten 10 begrenzt wird, aufgebracht. Auf dieser Kontaktschicht 2 befindet sich ein zentraler Kontakt 1. Lateral des Steges sind auf der lateralen Mantelschicht 15 streifenförmig übereinander eine Zwischenschicht 12, eine Ätzstoppschicht 13 und eine laterale Kontaktschicht 14 aufgebracht. Diese laterale Kontaktschicht 14 ist mit einem lateralen Kontakt 11 versehen. Die laterale Isolation erfolgt ebenfalls mit Isolatorschichten 10. Mit der unteren Mantelschicht 8 elektrisch leitend verbunden (z. B. durch das elektrisch leitend dotierte Substrat 8a) ist ein Gegenkontakt 9 aufgebracht. Der Anschlußbereich 15a ist in den Fig. 1 und 2 durch die strichpunktierte Linie angedeutet. In diesen Zeichnungen sind gesondert mit Bezugszeichen versehen ein oberer Anteil 3a und ein unterer Anteil 3b der oberen Mantelschicht 3 oberhalb bzw. unterhalb eines jeweiligen Abschnittes der Absorberschicht 4.

Die nachfolgende Tabelle enthält typische Daten einer erfindungsgemäßen Laserdiodenstruktur auf einem p-Substrat (vgl. dazu Fig. 1, 2 und 6).

Hinter dem Bezugszeichen der jeweiligen Schicht bzw. Zone ist die zugehörige Dicke in μm, danach die Funktion dieser Schicht und danach die Zusammensetzung und Dotierungshöhe des Materiales eingetragen.

| Schicht/ Zone | Dicke (μm) | Funktion | Zusammensetzung;Vorzeichen; Höhe der Dotierung |
|---|---|---|---|
| 1 | 0,5 | p-Laserkontakt | Ti/Pt/Au (p-Kontakt) |
| 2 | 0,2 | $p^+$-Kontaktschicht | $Q_{1,3}$; p ; $5 \times 10^{19}$ cm$^{-3}$ |
| 3 | 2,23 | p-Mantelschicht | InP ;p ;5 $\times 10^{17}$ cm$^{-3}$ |
| 3a | 2,0 | p-Mantelschicht | InP ;p ;5 $\times 10^{17}$ cm$^{-3}$ |
| 3b | 0,2 | p-Mantelschicht | InP ;p ;5 $\times 10^{17}$ cm$^{-3}$ |
| 4 | 0,03 | Absorber-Schicht | InGaAs ;p ;$10^{18}$ cm$^{-3}$ |
| 4a, 4b | 0,05 | Kompensationsschicht | $Q_{1,3}$; p ;5 $\times 10^{17}$ cm$^{-3}$ |
| 4c | 1,0 | Abstandsschicht | InP oder $Q_g$ (g < 1,3) ;p ;5 $\times 10^{17}$ cm$^{-3}$ |
| 5 | 0,25 | Wellenleiterschicht | $Q_{1,55}$ undotiert |
| 6 | 0,4 | Zwischenschicht | InP ;n ;3 $\times 10^{18}$ cm$^{-3}$ |
| 7 | 0,15 | Wellenleiterschicht | $Q_{1,3}$ undotiert |
| 8 | 1,0 | p-Mantelschicht | InP ;p ;5 $\times 10^{17}$ cm$^{-3}$ |
| 8a | 100 | p-Substrat | InP ;p ;5 $\times 10^{18}$ cm$^{-3}$ |
| 9 | 0,5 | p-Abstimmkontakt | Au/Zn/Au/Pt/Au |
| 10 | 0,2 | Isolator | $Al_2O_3$ |
| 11 | 0,5 | n-Kontakt | Ti/Pt/Au |
| 12 | 0,2 | Zwischenschicht | $Q_{1,3}$; n ;1 $\times 10^{18}$ cm$^{-3}$ |
| 13 | 0,1 | Ätzstopp-Schicht | InP ;n ;1 $\times 10^{18}$ cm$^{-3}$ |
| 14 | 0,2 | $n^+$-Kontaktschicht | InGaAs ;n ;5 $\times 10^{19}$ cm$^{-3}$ |
| 15 | 4,0 | laterale Mantelschicht | InP ;n ;2 $\times 10^{18}$ cm$^{-3}$ |
| 15a | 0,5 | $p^+$-Anschlußbereich | InP ;p ;3 $\times 10^{18}$ cm$^{-3}$ |

EP 0 552 390 B1

Q bedeutet in dieser Tabelle jeweils quaternäres Material, wobei der Index die entsprechende Wellenlänge und damit den Energiebandabstand angibt. Bei diesem Ausführungsbeispiel ist die obere Wellenleiterschicht 5 als aktive Schicht ausgebildet und die untere Wellenleiterschicht 7 als Abstimmschicht. Die Absorberschicht 4 ist oberhalb der oberen Wellenleiterschicht 5 angeordnet. Die Absorberschicht 4 kann stattdessen zwischen den Wellenleiterschichten 5, 7, also in der Zwischenschicht 6 eingebettet angeordnet sein oder unterhalb der unteren Wellenleiterschicht 7, d. h. auf der dem Substrat zugewandten Seite. Ebenso kann die Reihenfolge der Wellenleiterschichten 5,7 umgekehrt sein (oben Abstimmschicht, unten aktive Schicht). Das Dotierungsvorzeichen kann gegenüber den Angaben in der Tabelle umgekehrt sein. Die Funktionen des zentralen Kontaktes 1 und des Gegenkontaktes 9 sind dann ebenfalls vertauscht, d. h. der zentrale Kontakt 1 ist Abstimmkontakt und der Gegenkontakt 9 Laserkontakt.

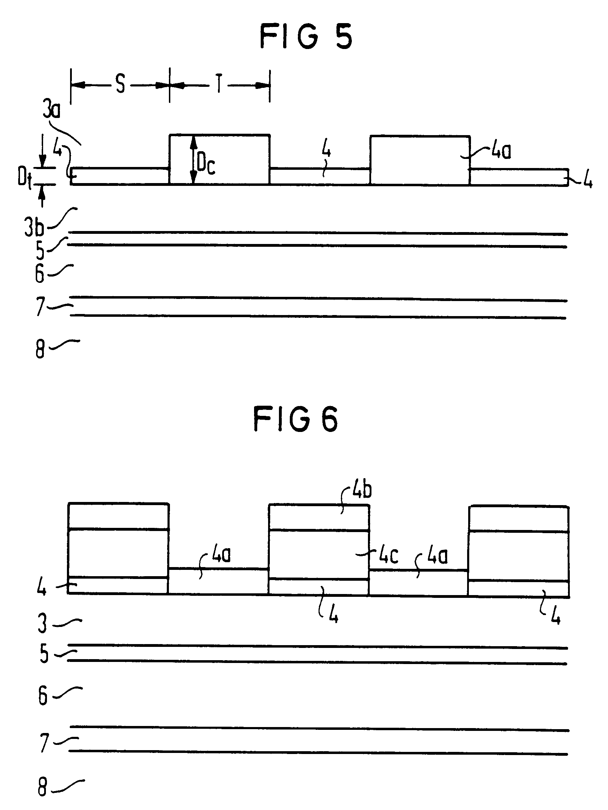

Die aufgelistete Kompensationsschicht 4a, 4b und die Abstandsschicht 4c dienen dazu, den Realteil des Brechungsindexes in den Wellenleiterschichten 5, 7 über die Länge der Laserdiode hinweg konstant zu halten, und werden weiter unten anhand der Figuren 5 und 6 beschrieben. Der Steuerstrom für die aktive Schicht zur Erzeugung der Laserstrahlung ist mit $I_a$ bezeichnet und der Strom zur Abstimmung mit $I_t$. Die Periode P der Absorberschicht 4 (Fig. 1) setzt sich zusammen aus einem jeweiligen Abschnitt dieser Absorberschicht 4 mit der Länge S und einer jeweiligen Unterbrechung der Länge T. Die Periode errechnet sich aus den effektiven (reellen) Brechzahlen $N_{e1}$ und $N_{e2}$ der beiden verkoppelten Moden und der Wellenlänge $\lambda$ zu

$$P = \frac{\lambda}{|N_{e1} - N_{e2}|} \quad (1)$$

wobei die Differenz $|N_{e1} - N_{e2}|$ typisch 0.1 beträgt. Es ist möglich, wie in der Figur gezeigt, S = T zu wählen. Die Längen S und T können aber auch verschieden sein, was bei der erfindungsgemäßen Laserdiode in der Regel von Vorteil sein wird. Wenn die Laserdiode aus InGaAsP besteht und bei 1,55 $\mu$m Wellenlänge arbeitet, ist die Periode P typisch ungefähr 20 $\mu$m.

Die Spiegelendflächen des Lasers, d. h. in Fig. 1 die links und rechts eingezeichneten Berandungen der Laserdiode, sollten so angeordnet sein, daß die Teilabschnitte der Absorberschicht 4 oder deren Unterbrechungen jeweils in der Mitte abgeschnitten sind. Dabei kann entweder wie in Fig. 1 am einen Ende der Laserdiode ein Abschnitt der Absorberschicht 4 durch die Spiegelendfläche halbiert sein und auf der anderen Seite die Spiegelendfläche im Abstand einer halben Unterbrechung von einem Abschnitt der Absorberschicht 4 entfernt angeordnet sein. Ebensogut können die Spiegelendflächen an beiden Enden jeweils einen Abschnitt der Absorberschicht 4 halbieren oder an beiden Enden im Abstand einer halben Unterbrechung von einem Abschnitt der Absorberschicht 4 entfernt verlaufen. Die Breite W der stegförmigen Anordnung der Schichten beträgt vorteilhaft etwa 1 bis 2 $\mu$m.

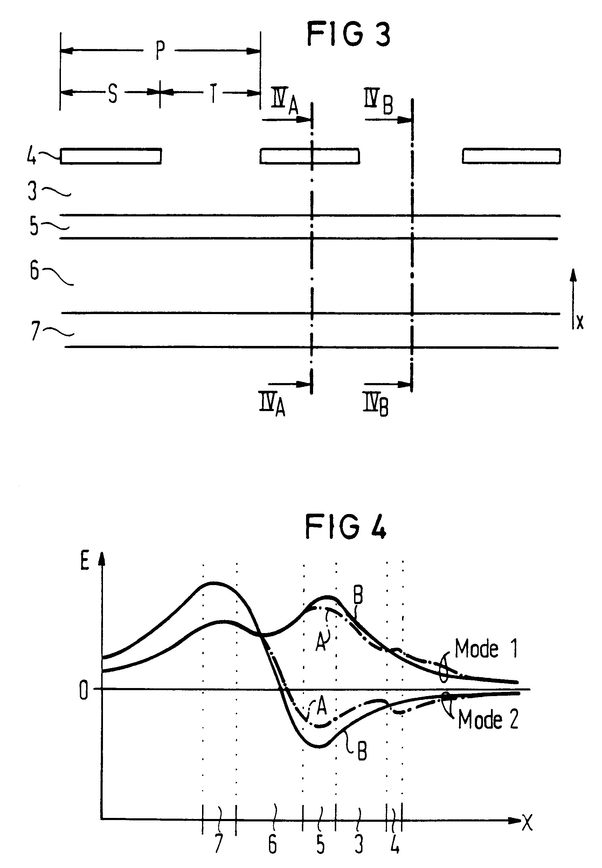

Fig. 3 zeigt einen Ausschnitt des Längsschnittes von Fig. 1. In dieser Fig. 3 sind zwei Schnittebenen A und B eingezeichnet. Die Feldstärke E (z. B. E-Feld-Komponente senkrecht zur Zeichenebene) der beiden verkoppelten Moden 1 und 2 ist in Fig. 4 für diese beiden Schnittebenen in Abhängigkeit vom Ort in der vertikalen Richtung x eingetragen. Die durchgezogenen Kurven beziehen sich jeweils auf den Schnitt B im Gebiet, in dem die Absorberschicht 4 unterbrochen ist. Die strichpunktierte Kurve zeigt die Feldstärke im Gebiet der Absorberschicht 4 (Schnitt A). Die Änderung der Feldstärke im Gebiet der Absorberschicht 4 bewirkt die Kopplung mit von 0 verschwindendem Imaginärteil des Koppelgrades.

In den Fig. 5 und 6 sind jeweilige Längsschnitte dargestellt, bei denen die Unterbrechungen zwischen den Abschnitten der Absorberschicht 4 jeweils durch Anteile einer Kompensationsschicht 4a aufgefüllt sind. Ein wesentliches Merkmal der vorliegenden Erfindung ist die praktische Realisierung einer imaginären Koppelstärke durch die Absorberschicht 4. Die üblichen Halbleitermaterialien, die für eine solche Absorberschicht 4 eingesetzt werden können, ändern aber nicht nur den Imaginärteil des Brechungsindexes in den Wellenleiterschichten, was zur Erzielung der imaginären Koppelstärke erforderlich ist, sondern auch den Realteil des effektiven Brechungsindexes. Daher muß die Änderung des Realteiles des Brechungsindexes durch eine Kompensation beseitigt werden, so daß die Absorberschicht 4 im Idealfall eine ausschließlich imaginäre Änderung des Brechungsindexes und damit der Koppelstärke hervorruft. Das kann durch Auffüllen der Bereiche zwischen den Abschnitten der Absorberschicht 4 mit Material einer höheren Brechzahl als der oberen Mantelschicht 3 erfolgen, wobei dieses Material aber nicht absorbiert. Das ist im Prinzip vom BIG-Laser her bekannt (s. z. B. Y. Tohmori u.a.:"Novel Structure GaInAsP/InP 1.5 - 1.6 $\mu$m Bundle Integrated-Guide (BIG) Distributed Bragg Reflector Laser" in Jap. J. Appl. Phys. 24, L399 - L401 (1985)). Die Kompensationsschicht 4a soll möglichst im selben Abstand von der Wellenleiterschicht 5 wie die Absorberschicht 4 vorhanden sein. Die Dicke $D_c$ dieser Kompensationsschicht 4a sollte in etwa den Wert besitzen, der sich mit der Dicke $D_t$ der Absorberschicht 4 näherungsweise aus folgender Formel ergibt:

$$D_c(N_{4a} - N_3) = D_t(N_4 - N_3), \quad (2)$$

wobei $N_n$ der Realteil des Brechungsindexes der mit dem Bezugszeichen n versehenen Schicht ist.

Die Anordnung nach Fig. 5 läßt sich z. B. durch selektive Epitaxie herstellen. Nach dem Herstellen der Absorberschicht 4, d. h. dem ganzflächigen Aufwachsen mit anschließendem Ausätzen der Unterbrechungen, wird diese Absorberschicht 4 durch Masken abgedeckt und die Unterbrechungen mit der Kompensationsschicht 4a aufgefüllt. Ohne selektive Epitaxie kommt man aus, wenn man den Aufbau nach Fig. 6 realisiert. Dabei wird zusätzlich zu der Absorberschicht 4 eine Abstandsschicht 4c ganzflächig aufgewachsen. Die Absorberschicht und diese Abstandsschicht 4c werden gemeinsam in den Bereichen der Unterbrechungen der Absorberschicht 4 ausgeätzt. Danach wird ganzflächig die Kompensationsschicht 4a, 4b aufgewachsen, wobei die Anteile 4b der Kompensationsschicht auf den Anteilen der Abstandsschicht 4c so weit von den Wellenleiterschichten 5, 7 entfernt sind, daß eine Änderung des Realteiles des effektiven Brechungsindexes in diesen Wellenleiterschichten 5, 7 praktisch nicht auftritt. Diese aus der Absorberschicht 4 und der Kompensationsschicht 4a zusammengesetzte Schicht wird mit dem oberen Anteil 3a der oberen Mantelschicht 3 ganzflächig überwachsen und planarisiert.

Wesentlich für die erfindungsgemäße Laserdiode ist eine ausgeprägte schmale Filterkurve, d. h. die relative optische Verstärkung in der Einheit einer reziproken Weglänge aufgetragen über der Wellenlänge. Die Höhe dieser Filterkurve und deren Breite sind bei rein imaginärer Koppelstärke jeweils proportional zum Imaginärteil dieser Koppelstärke. Die Höhe der Filterkurve ist zusätzlich proportional zur Differenz der effektiven Brechzahlen für die beiden Moden in den Wellenleiterschichten. Damit ist die Filterkurve deutlich steiler als die durch die Materialverstärkung erzeugte Wellenlängenabhängigkeit. Das ermöglicht die Frequenz- bzw. Wellenlängenverstimmung mittels der Vorwärtskopplung über den Strom $I_t$. Die Abstimmung mittels $I_t$ ändert die Brechzahl der Wellenleiterschicht 7 aufgrund der Ladungsträgerinjektion. Eine Änderung der Brechzahl ist aber auch unter Ausnutzung des Quantum-confined-Stark-Effekts möglich, wenn die Wellenleiterschicht 7 eine Quantum-well-Struktur besitzt. Dann wird bei Sperrpolung des Gegenkontaktes 9 die Brechzahl reduziert, ohne daß ein Strom fließt ($I_t = 0$). Die Brechzahländerung in der Wellenleiterschicht 7 beeinflußt die effektiven Brechzahlen $N_{e1}$ und $N_{e2}$ der beiden Moden 1 und 2 unterschiedlich, so daß gemäß Formel (1) aufgrund der konstanten Periode P die relativen Wellenlängenänderungen proportional zur relativen Änderung der Differenz $|N_{e1} - N_{e2}|$ sind. Die Periode P der Absorberschicht 4 ist etwa 10 mal bis 100 mal größer als die Periode eines DFB-Gitters.

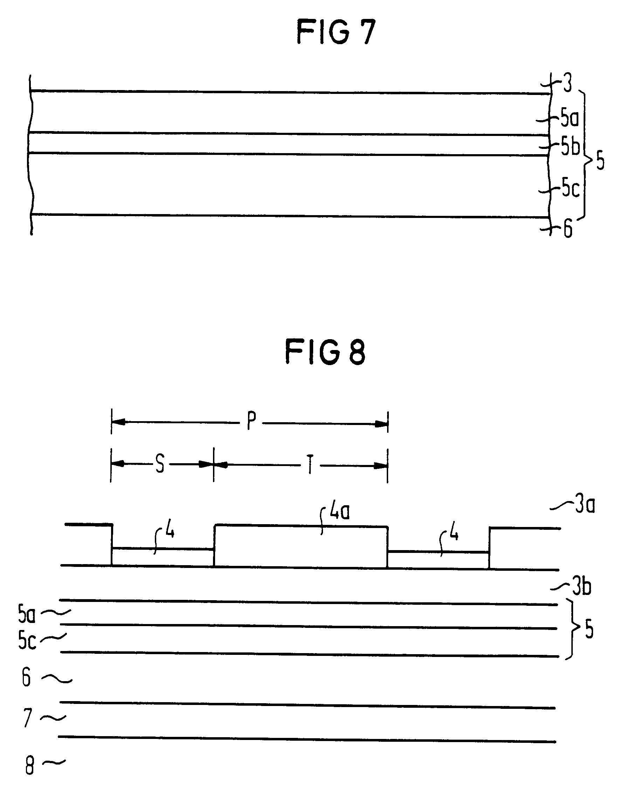

Die erfindungsgemäße Laserdiode läßt sich prinzipiell auch durch Substitution der Absorberschicht 4 durch eine verstärkende Schicht realisieren. Ebenso kann die Wellenleiterschicht 5 in zwei oder mehrere Schichten aufgeteilt werden, wobei die Wellenleiterfunktion teilweise von nicht verstärkenden Schichten (z. B. $Q_{1,3}$ bei = 1.55 µm) übernommen werden kann. Eine derartige Ausführungsform ist beispielweise in Fig. 7 ausschnittsweise gezeigt. Dabei entspricht Schicht 5a der ursprünglichen Schicht 5 in ihrer Zusammensetzung, während Schicht 5b z. B. wie die obere Mantelschicht 3 zusammengesetzt sein kann, und Schicht 5c besteht z. B. aus quaternärem Material ($Q_{1,3}$, n-dotiert). Typische Schichtdicken sind 0,1 µm, 0,05 µm und 0,2 µm für die Schichten 5a, 5b, 5c. In Fig. 8 ist ein Fig. 5 entsprechender Längsschnitt durch ein alternatives Ausführungsbeispiel mit Schichten 5a und 5c anstelle der in Fig. 5 gezeigten Wellenleiterschicht 5 dargestellt. Die Dicken der Schichten 4, 4a, 5a, 5c, 6 und 7 sind resp. 0,07 µm, 0,15 µm, 0,15 µm, 0,2 µm, 0,3 µm und 0,2 µm. Die Materialzusammensetzung der Schicht 5a ist die gleiche wie die der Schicht 5. Die Schicht 5c ist quaternäres Material ($Q_{1,3}$), n-leitend mit $5 \times 10^{17}$ cm$^{-3}$ Dichte dotiert. Dieses Ausführungsbeispiel ist für die Wellenlänge 1,55 µm und die Abmessungen W = 1,5 µm, P = 15,5 µm, S = 4,5 µm und T = 11 µm angegeben. Die Angaben für die übrigen Schichten sind der obenstehenden Tabelle zu entnehmen.

Die wesentlichen Merkmale der erfindungsgemäßen Laserdiode sind die transversale doppelte Wellenleiterstruktur, die transversal dazu angeordnete periodisch unterbrochene Absorberschicht und die dadurch bewirkte Vorwärtskopplung zweier verschiedener Moden. Die Anordnung und Dotierung der Schichten für eine getrennte Strominjektion in die beiden Wellenleiterschichten sowie die Abmessungen der Schichten können im einzelnen Ausführungsbeispiel in weiten Grenzen variiert werden. Damit erhält man auf einfache Weise eine Vielzahl verschiedener einfach herstellbarer und breitbandig abstimmbarer Laserdioden.

**Patentansprüche**

1.  Abstimmbare Laserdiode,
    bei der zwei, eine aktive Schicht (5 oder 7) und eine Abstimmschicht (7 bzw. 5) bildende sowie je einen Mode führende Wellenleiterschichten (5, 7) transversal zu den Schichtebenen parallel zueinander angeordnet sind und
    bei der durch eine zwischen diesen Wellenleiterschichten (5, 7) befindliche Zwischenschicht (6) eine getrennte Strominjektion in jede der beiden Wellenleiterschichten (5, 7) möglich ist,
    **dadurch gekennzeichnet,**
    daß transversal zu den Schichtebenen parallel zu den Wellenleiterschichten (5, 7) eine in Langsrichtung der Wellenleiterschichten (5, 7) periodisch unterbrochene Absorberschicht (4) angeordnet ist, wobei die Länge einer Periode (P) der Absorberschicht (4) zumindest näherungsweise gleich dem Quotienten aus der Wellenlänge der von der Laserdiode in Luft abgestrahlten Strahlung und dem Betrag der Differenz der Realteile der effektiven Brechzahlen der beiden verkoppelten Moden ist.

2. Laserdiode nach Anspruch 1,
bei der die Wellenleiterschichten (5, 7) quaternäre Halbleitermaterialien sind und die Absorberschicht (4) ternäres Halbleitermaterial ist.

3. Laserdiode nach Anspruch 1 oder 2,
bei der auf einem Substrat (8a) in einer stegförmigen Anordnung übereinander die durch die Zwischenschicht (6) getrennten Wellenleiterschichten (5, 7) zwischen einer unteren Mantelschicht (8) und einer oberen Mantelschicht (3) sowie die Aborberschicht (4) aufgewachsen sind,
bei der diese stegförmige Anordnung von einer lateralen Mantelschicht (15) eingefaßt ist,
bei der die Wellenleiterschichten (5, 7) undotiert sind, bei der die Zwischenschicht (6) und die laterale Mantelschicht (15) für elektrische Leitung eines ersten Leitungstyps dotiert sind,
bei der die untere Mantelschicht (8), die obere Mantelschicht (3) und die Absorberschicht (4) für elektrische Leitung des zweiten Leitungstyps dotiert sind und
bei der gesonderte Kontakte (1, 9, 11) vorhanden sind, von denen jeweils einer mit der unteren Mantelschicht (8), mit der oberen Mantelschicht (3) und mit der lateralen Mantelschicht (15) elektrisch leitend verbunden ist.

4. Laserdiode nach einem der Ansprüche 1 bis 3,
bei der in den Unterbrechungen zwischen den Abschnitten der Absorberschicht (4) jeweils Abschnitte einer Kompensationsschicht (4a) vorhanden sind, um die Realteile der effektiven Brechungszahlen in den Wellenleiterschichten (5, 7) über die Länge der Laserdiode möglichst konstant zu halten.

## Claims

1. Tunable laser diode in which the two waveguide layers (5, 7), which form an active layer (5 or 7) and a tunable layer (7 or 5, respectively) and each conduct a mode, are arranged parallel to one another transverse to the layer planes, and in which owing to an intermediate layer (6) located between these waveguide layers (5, 7) a separate current injection into each of the two waveguide layers (5, 7) is possible, characterized in that an absorber layer (4) periodically interrupted in the longitudinal direction of the waveguide layers (5, 7) is arranged transverse to the layer planes and parallel to the waveguide layers (5, 7), the length of a period (P) of the absorber layer (4) being at least approximately equal to the quotient of the wavelength of the radiation emitted by the laser diode in air and the absolute value of the difference of the real parts of the effective refractive indices of the two coupled modes.

2. Laser diode according to Claim 1, in which the waveguide layers (5, 7) are quaternary semiconductor materials, and the absorber layer (4) is ternary semiconductor material.

3. Laser diode according to Claim 1 or 2, in which there are grown one above another on a substrate (8a) in a ridge-shaped arrangement between a lower cladding layer (8) and an upper cladding layer (3), the waveguide layers (5, 7), which are separated by the intermediate layer (6), and the absorber layer (4), in which this ridge-shaped arrangement is lined by a lateral cladding layer (15), in which the waveguide layers (5, 7) are undoped, in which the intermediate layer (6) and the lateral cladding layer (15) are doped for electric conduction of a first conductivity type, in which the lower cladding layer (8), the upper cladding layer (3) and the absorber layer (4) are doped for electric conduction of the second conductivity type, and in which separate contacts (1, 9, 11) are present, of which in each case one is connected in an electrically conductive fashion to the lower cladding layer (8), to the upper cladding layer (3) and to the lateral cladding layer (15).

4. Laser diode according to one of Claims 1 to 3, in which in the interruptions between the sections of the absorber layer (4) sections of a compensation layer (4a) are respectively present in order to keep the real parts of the effective refractive indices as constant as possible in the waveguide layers (5, 7) over the length of the laser diode.

**Revendications**

1. Diode laser accordable,
dans laquelle deux couches formant guides d'ondes (5,7), qui forment une couche active (5 ou 7) et une couche d'accord (7 ou 5) et véhiculent chacune un mode, sont disposées parallèlement l'une à l'autre, transversalement par rapport aux plans des couches, et
dans laquelle une injection séparée de courant est possible dans chacune des deux couches formant guides d'ondes (5,7), au moyen d'une couche intermédiaire (6) située entre ces couches formant guides d'ondes (5,7),
caractérisée par le fait qu'une couche d'absorption (4), interrompue périodiquement dans la direction longitudinale des couches formant guides d'ondes (5,7), est disposée transversalement par rapport aux plans des couches, parallèlement aux couches formant guides d'ondes (5,7), la longueur d'une période (P) de la couche d'absorption (4) étant au moins approximativement égale au quotient de la longueur d'onde du rayonnement émis dans l'air par la diode laser, par la valeur absolue de la différence des parties réelles des indices de réfraction effectifs des deux modes couplés.

2. Diode laser suivant la revendication 1, dans laquelle les couches formant guides d'ondes (5,7) sont des matériaux semiconducteurs quaternaires, et la couche d'absorption (4) est formée d'un matériau semiconducteur ternaire.

3. Diode laser suivant la revendication 1 ou 2, dans laquelle les couches formant guides d'ondes (5,7), qui sont séparées par la couche intermédiaire (6), sont formées par croissance sur un substrat (8a), en superposition selon une disposition en forme de barrettes, entre une couche enveloppe inférieure (8) et une couche enveloppe supérieure (3) ainsi que la couche d'absorption (4),
dans laquelle cet ensemble en forme de barrettes est bordé par une couche enveloppe latérale (15),
dans laquelle les couches formant guides d'ondes (5,7) ne sont pas dopées,
dans laquelle la couche intermédiaire (6) et la couche enveloppe latérale (15) sont dopées pour l'obtention d'une conduction électrique d'un premier type,
dans laquelle la couche enveloppe inférieure (8), la couche enveloppe supérieure (3) et la couche d'absorption (4) sont dopées pour l'obtention d'une conduction électrique du second type,
dans laquelle sont respectivement prévus des contacts séparés (1,9,11), dont l'un est relié d'une manière électriquement conductrice à la couche enveloppe inférieure (8), à la couche enveloppe supérieure (3) et la couche enveloppe latérale (15).

4. Diode laser suivant l'une des revendications 1 à 3, dans laquelle respectivement des parties d'une couche de compensation (4a) sont présentes dans les interruptions qui existent entre les parties de la couche d'absorption (4), pour maintenir à une valeur aussi constante que possible les parties réelles des indices de réfraction effectifs dans les couches formant guides d'ondes (5,7), sur la longueur de la diode laser.

EP 0 552 390 B1

# FIG 1

# FIG 2

9

# FIG 3

# FIG 4

# FIG 5

# FIG 6

EP 0 552 390 B1

# FIG 7

3
5a
5b } 5
5c
6

# FIG 8

P
S    T

4a    3a
4    4
3b
5a
5c } 5
6
7
8

12